(19) Europäisches Patentamt
European Patent Office
Office européen des brevets

(11) **EP 4 637 174 A1**

(12) **EUROPEAN PATENT APPLICATION**

(43) Date of publication:
**22.10.2025 Bulletin 2025/43**

(21) Application number: **25169351.1**

(22) Date of filing: **09.04.2025**

(51) International Patent Classification (IPC):
*H04N 25/532* (2023.01)    *H04N 25/616* (2023.01)
*H04N 25/709* (2023.01)    *H04N 25/771* (2023.01)
*H04N 25/778* (2023.01)    *H04N 25/78* (2023.01)
*H04N 25/79* (2023.01)     *H04N 23/73* (2023.01)
*H10F 39/00* (2025.01)

(52) Cooperative Patent Classification (CPC):
H04N 25/771; H04N 23/73; H04N 25/532;
H04N 25/616; H04N 25/709; H04N 25/778;
H04N 25/78; H04N 25/79; H10F 39/8037;
H04N 25/60

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **15.04.2024 JP 2024065613**

(71) Applicant: **CANON KABUSHIKI KAISHA**
**Tokyo 146-8501 (JP)**

(72) Inventors:
• **YAMASHITA, Takanori**
**Tokyo, 146-8501 (JP)**
• **ARISHIMA, Yu**
**Tokyo, 146-8501 (JP)**

(74) Representative: **TBK**
**Bavariaring 4-6**
**80336 München (DE)**

(54) **PHOTOELECTRIC CONVERSION DEVICE AND EQUIPMENT**

(57)    A photoelectric conversion device including a pixel array and a read circuit having a plurality of column circuits configured to read signals from the pixel array. Each pixel includes a photoelectric converter to accumulate charges corresponding to incident light, a charge-voltage converter, a transporter to transport charges from the photoelectric converter to the charge-voltage converter, a first amplification transistor to amplify a voltage of the charge-voltage converter, a first current source to supply a first current to the first amplification transistor, a storage to hold an output of the first amplification transistor, and a second amplification transistor to amplify a voltage supplied from the storage. Each column circuit includes a second current source to supply a second current to the second amplification transistor. The first current is smaller than the second current.

FIG. 3

**Description**

BACKGROUND OF THE INVENTION

Field of the Invention

The present invention relates to a photoelectric conversion device and equipment.

Description of the Related Art

Japanese Patent Laid-Open No. 2022-51548 describes a global shutter type CMOS image sensor in which each pixel includes a memory for holding a signal. In the global shutter method, a charge accumulation operation starts and ends simultaneously in all pixels.

However, in the global shutter type CMOS image sensor, since an operation of writing, in the memory, a signal corresponding to charges accumulated in a photoelectric converter is performed simultaneously in all pixels, the peak value of current consumption can be significantly large.

SUMMARY OF THE INVENTION

The present invention provides a technique advantageous in suppressing the peak value of current consumption.

The present invention in its first aspect provides a photoelectric conversion device as specified in claims 1 to 15.

The present invention in its second aspect provides equipment as specified in claim 16.

Further features of the present invention will become apparent from the following description of exemplary embodiments with reference to the attached drawings.

BRIEF DESCRIPTION OF THE DRAWINGS

Fig. 1 is a view schematically showing an example of the arrangement of a photoelectric conversion device according to an embodiment;

Fig. 2 is a functional block diagram showing the example of the arrangement of the photoelectric conversion device according to the embodiment;

Fig. 3 is a circuit diagram showing an example of the arrangement of one pixel and a portion of one column circuit in the photoelectric conversion device exemplarily shown in Figs. 1 and 2;

Figs. 4A to 4C are views showing three operation modes;

Fig. 5 is a timing chart exemplarily showing a write operation in a period B;

Fig. 6 is a timing chart exemplarily showing a read operation in a period C;

Fig. 7 is a view showing an arrangement in which a pixel array is divided into a plurality of blocks;

Fig. 8 is a timing chart exemplarily showing a partial global shutter mode; and

Fig. 9 is a view showing an example of the arrangement of equipment according to an embodiment.

DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

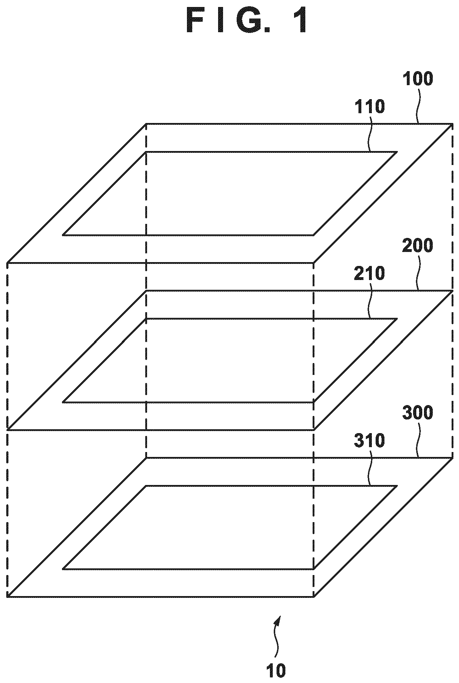

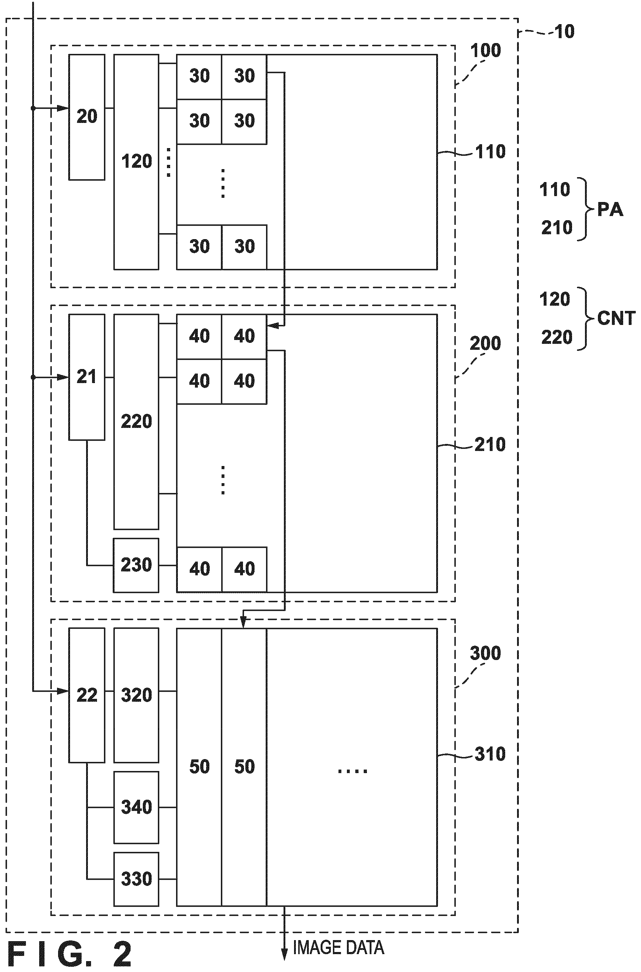

Fig. 1 shows an example of the arrangement of a photoelectric conversion device 10 according to an embodiment. Fig. 2 shows a functional block diagram of the photoelectric conversion device 10 exemplarily shown in Fig. 1. The photoelectric conversion device 10 can be configured as, for example, an image sensor that generates image data by capturing an optical image and outputs the image data. Alternatively, the photoelectric conversion device 10 can be configured as, for example, a sensor that generates image data by capturing an optical image and outputs information obtained by processing the image data. In the arrangement example shown in Fig. 1, the photoelectric conversion device 10 can be formed by stacking three substrates 100, 200, and 300. Each of the first substrate 100, the second substrate 200, and the third substrate 300 can include a semiconductor layer and a wiring structure. However, this is merely an example, and the photoelectric conversion device 10 may be formed by a single substrate, two substrates, or four or more substrates.

The first substrate 100 can include a first array 110 where a plurality of first pixel components 30 are arranged to form a plurality of rows and a plurality of columns, a first control circuit 20, and a first vertical scanning circuit 120. The second substrate 200 can include a second array 210 where a plurality of second pixel components 40 are arranged to form a plurality of rows and a plurality of columns, a second control circuit 21, a second vertical scanning circuit 220, and a bias generation circuit 230. One first pixel component 30 and one second pixel component 40 can constitute one pixel (a pixel PIX to be described later). That is, the first substrate 100 and the second substrate 200 can constitute a pixel array PA where a plurality of pixels are arranged to form a plurality of rows and a plurality of columns.

The first vertical scanning circuit 120 is configured to control, for example, accumulation of charges in the photoelectric converter of each of the plurality of pixels, transport of charges from the photoelectric converter to a charge-voltage converter, reset of the charge-voltage converter, and output of a signal corresponding to the voltage of the charge-voltage converter. The first control circuit 20 can be configured to control the first vertical scanning circuit 120. The second vertical scanning circuit 220 can be configured to control, for example, a write operation of writing a signal in a storage and a read operation of a signal from the storage in each of the plurality of pixels. The second control circuit 21 can be configured to control the second vertical scanning circuit 220 and the bias generation circuit 230. The bias generation circuit 230 can be configured to generate a bias voltage for controlling the first current source (to be described later) in each pixel, or the like. The first vertical scanning circuit 120 and the second vertical scanning circuit 220 constitute a controller CNT that controls the plurality of pixels.

The third substrate 300 can include a read circuit 310 including a plurality of column circuits 50 configured to read signals from the pixel array PA, a column control circuit 320 configured to control the plurality of column circuits 50 of the read circuit 310, a bias generation circuit 330, a ramp generator 340, and a third control circuit 22. The third control circuit 22 controls the column control circuit 320, the bias generation circuit 330, and the ramp generator 340. Each column circuit 50 is arranged to read signals from the pixels forming the corresponding column among the plurality of columns of the pixel array PA. The bias generation circuit 330 can be configured to generate a bias voltage for controlling the second current source (to be described later) in each pixel, or the like. The ramp generator 340 can be configured to generate a ramp signal RAMP (to be described later) used for AD conversion and supply it to the plurality of column circuits 50.

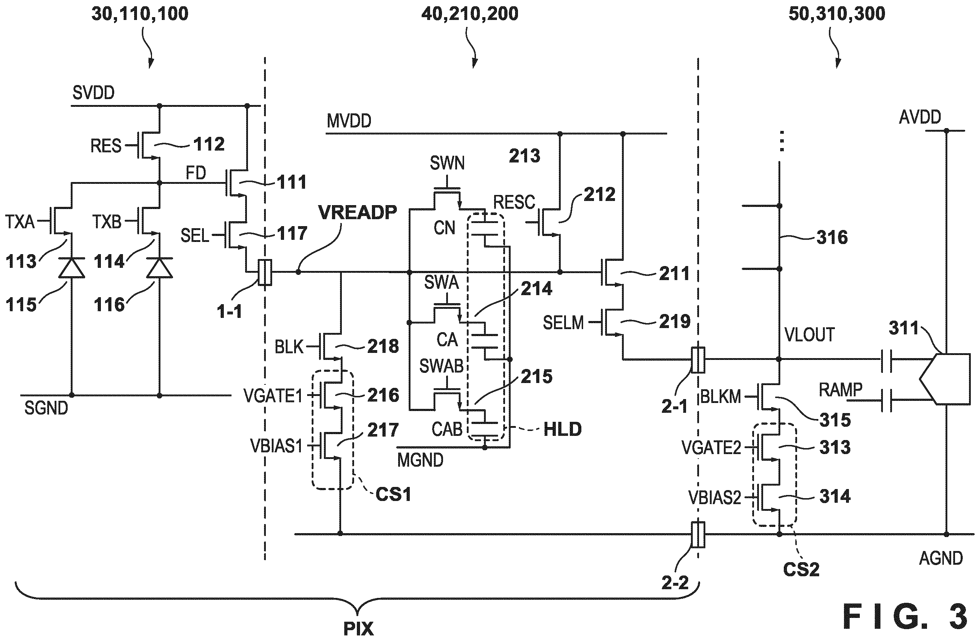

Fig. 3 shows an example of the arrangement of one pixel PIX and a portion of one column circuit 50 in the photoelectric conversion device 10 exemplarily shown in Figs. 1 and 2. One pixel PIX can be constituted by one first pixel component 30 and one second pixel component 40.

The first pixel component 30, which can be arranged in the first substrate 100, can include, for example, two photoelectric converters 115 and 116, but it may include only one photoelectric converter or three or more photoelectric converters. The first pixel component 30 can include a charge-voltage converter FD, transporters 113 and 114 that individually transport charges accumulated in the photoelectric converters 115 and 116 to the charge-voltage converter FD, and a first reset unit 112 that resets the charge-voltage converter FD. The charge-voltage converter FD is a capacitance that converts charges into a voltage, and can include, for example, a floating diffusion formed by a diffusion region of the semiconductor layer, and a parasitic capacitance. The first pixel component 30 can also include a first amplification transistor 111 that amplifies the voltage of the charge-voltage converter FD. The first pixel component 30 may further include a first selection transistor 117, but the first selection transistor 117 can be omitted.

The second pixel component 40, which can be arranged in the second substrate 200, can include, for example, a first current source CS1, a first current source switching transistor 218 (first control transistor), a storage HLD, and sample/hold switches 213, 214, and 215. The second pixel component 40 can also include a second amplification transistor 211, a second selection transistor 219, and a second reset unit 212.

The column circuit 50 (read circuit 310), which can be arranged in the third substrate 300, can include a second current source switching transistor 315 (second control transistor), a second current source CS2, a read line 316, and a comparator circuit 311.

Each of the photoelectric converters 115 and 116 includes an anode and a cathode. The anodes of the photoelectric converters 115 and 116 can be connected to a ground potential SGND or a predetermined potential for the photoelectric converters 115 and 116. Each of the cathodes of the photoelectric converters 115 and 116 can be connected to one of the source and drain of transistors forming the transporters 113 and 114 respectively. Transport signals TXA and TXB are supplied from the first vertical scanning circuit 120 to the gates of the transistors forming the transporters 113 and 114, respectively. The other of the source and drain of each of the transistors forming the transporters 113 and 114 can be connected to the charge-voltage converter FD.

One of the source and drain of the transistor forming the first reset unit 112 can be connected to the charge-voltage converter FD, and the other can be connected to a power supply potential SVDD for the photoelectric converters 115 and 116. A first reset signal RES is supplied from the first vertical scanning circuit 120 to the gate of the transistor forming the first reset unit 112. The gate of the first amplification transistor 111 can be connected to the charge-voltage converter FD, one of the source and drain of the first amplification transistor 111 can be connected to the power supply potential SVDD, and the other can be connected to one of the source and drain of the first selection transistor 117. The other of the source and drain of the first selection transistor 117 can be connected to a read node VREADP of the second substrate 200 from the first substrate 100 via a first connection part 1-1. A first selection signal SEL is supplied from the first vertical scanning circuit 120 to the gate of the first selection transistor 117. The first amplification transistor 111 and the first current source CS1 constitute the first source follower amplification circuit.

The read node VREADP can be connected to the first current source CS1 via the first current source switching transistor 218. A block selection signal BLK can be supplied from the first vertical scanning circuit 120 to the gate of the first current source switching transistor 218. The first current source CS1 can include, for example, a series connection of a first current source transistor 217 and a first cascode transistor 216, but may be formed by a single current source transistor or have another arrangement. Control voltages VBIAS1 and VGATE1 can be supplied from the bias generation circuit 230 to the gates of the first current source transistor 217 and the first cascode transistor 216, respectively. One of the source and drain of the first current source switching transistor 218 can be connected to the read node VREADP, and the other can be connected to, for example, the first cascode transistor 216. One of the source and drain of the first current source transistor 217 is connected to the first cascode transistor 216, and the other is connected to an analog circuit ground potential AGND.

One of the source and drain of each of the sampling switches 213, 214, and 215 can be connected to the read node VREADP. The other of the source and drain of each of the sampling switches 213, 214, and 215 can be connected to one end of each of memories (hold capacitances) CN, CA, and CAB, respectively. The other end of each of the memories CN, CA, and CAB can be connected to a memory ground potential MGND. Control signals SWN, SWA, and SWAB can be supplied from the second vertical scanning circuit 220 to the gates of the sampling switches 213, 214, and 215, respectively. One of the source and drain of the transistor forming the second reset unit 212 can be connected to a memory power supply potential MVDD, and the other can be connected to the read node VREADP.

The gate of the second amplification transistor 211 can be connected to the read node VREADP, one of the source and drain can be connected to the memory power supply potential MVDD, and the other can be connected to one of the source and drain of the second selection transistor 219. The other of the source and drain of the second selection transistor 219 can be connected to an output node VLOUT of the third substrate 300 from the second substrate 200 via a second connection part 2-1. A second selection signal SELM can be supplied from the second vertical scanning circuit 220 to the gate of the second selection transistor 219.

The output node VLOUT includes the read line (vertical signal line) 316 arranged to extend in the column direction, and is connected to the pixel PIX (the second amplification transistor 211 thereof) in the row selected by the second selection signal SELM among the pixels PIX arranged in one column.

The output node VLOUT can be connected to the second current source CS2 via the second current source switching transistor 315. A block selection signal BLKM can be supplied from the column control circuit 320 to the gate of the second current source switching transistor 315. The second current source CS2 can include, for example, a series connection of a second current source transistor 314 and a second cascode transistor 313, but may be formed by a single current source transistor or have another arrangement. The second amplification transistor 211 and the second current source CS2 constitute the second source follower amplification circuit. Control voltages VBIAS2 and VGATE2 can be supplied from the bias generation circuit 330 to the gates of the second current source transistor 314 and the second cascode transistor 313, respectively. One of the source and drain of the second current source switching transistor 315 can be connected to the output node VLOUT, and the other can be connected to, for example, the second cascode transistor 313. One of the source and drain of the second current source transistor 314 is connected to the second cascode transistor 313, and the other is connected to the ground potential AGND. The ground potential AGND of the third substrate 300 can be connected to the ground potential AGND of the second substrate 200 via a second connection part 2-2.

Furthermore, the output node VLOUT can be connected to one differential input terminal of the comparator circuit 311 connected to an analog circuit power supply potential AVDD and the analog circuit ground potential AGND. The ramp signal RAMP can be supplied from the ramp generator 340 to the other differential input terminal of the comparator circuit 311. Note that, based on a comparison result as an output of the comparator circuit 311, an image signal is converted from an analog signal into a digital signal.

In the example described above, by isolating the power supply potentials SVDD, MVDD, and AVDD and the ground potentials SGND, MGND, and AGND from each other, the influence of a fluctuation of the power supply potential on other circuits is reduced. However, the present invention is not limited to the above-described example, and a common power supply potential and a common ground potential may be used.

In the example described above, the cascode transistors 216 and 313 are provided to suppress current changes caused by fluctuations of the drain voltages of the current source transistors 217 and 314. However, if current changes caused by fluctuations of the drain voltages of the current source transistors 217 and 314 are small, the cascode transistors 216 and 313 are unnecessary.

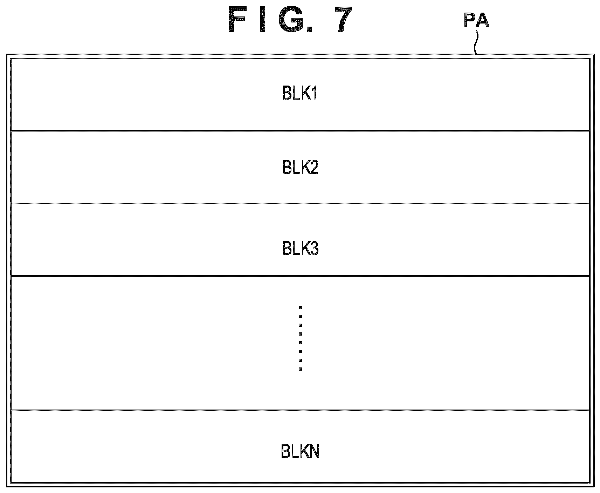

The photoelectric conversion device 10 can be configured to control the plurality of pixels PIX by a partial global shutter (PGS) method. Alternatively, the vertical driving circuit 30 can have a partial global shutter mode for controlling the plurality of pixels PIX by the partial global shutter (PGS) method, and a global shutter mode for controlling the plurality of pixels PIX by a global shutter (GS) method. Mode control can be performed by, for example, a mode instruction signal to a main controller (not shown) from the outside. The partial global shutter (PGS) method is a method in which the plurality of pixels PIX constituting the pixel array PA are divided into a plurality of blocks as shown in Fig. 7, and the pixels are driven for each block by the global shutter method. Each block can include the pixels arranged in the same row, and the pixels arranged in different rows. In other words, each block can include an arbitrary number of pixels PIX whose positions are specified by two or more rows and two or more columns.

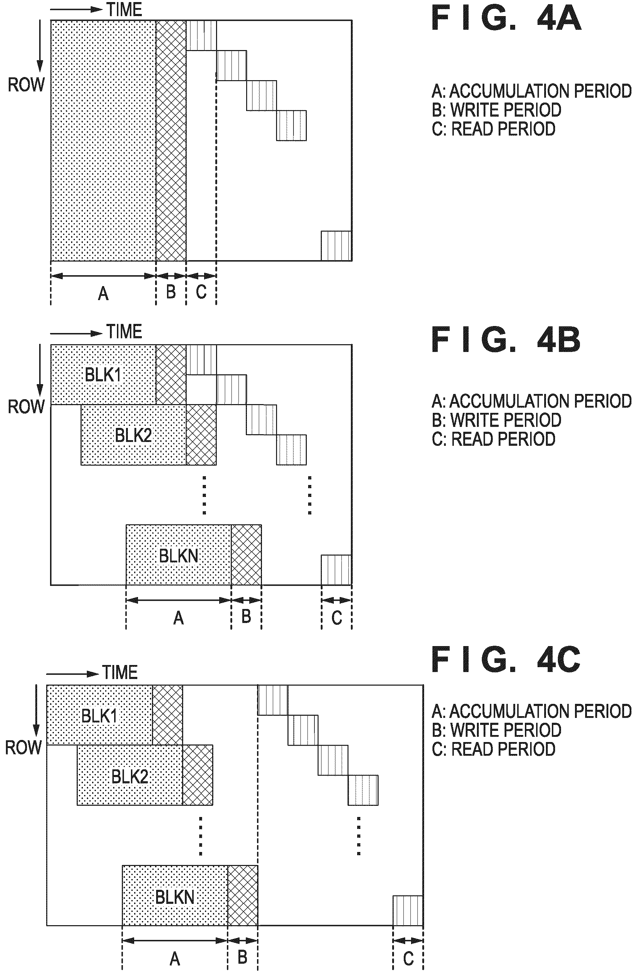

Fig. 4A schematically shows the operation of the photoelectric conversion device 10 in the global shutter (GS) mode. A period A is an accumulation period during which the photoelectric converters 115 and 116 accumulate charges. A period B is a write period during which a signal (noise level or optical signal) corresponding to charges accumulated by the photoelectric converters 115 and 116 is written in the storage HLD (memories CN, CA, and CAB). A period C is a read period during which signals are read from the plurality of pixels PIX (storages HLD thereof) constituting the pixel array PA with one or a predetermined number of rows as a unit. In the global shutter mode, the operation in the period A is performed simultaneously in all pixels PIX, and the operation in the period B is performed simultaneously in all pixels PIX. Furthermore, in the global shutter mode, the operation in the period C is performed such that signals are sequentially read from the pixel array with one or the predetermined number of rows as a unit.

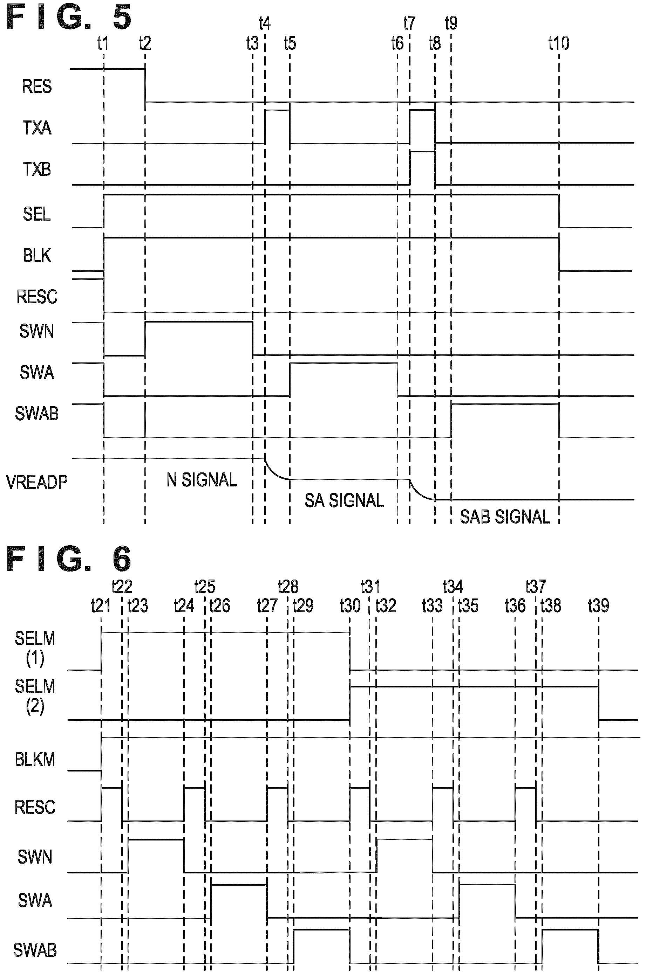

Fig. 5 exemplarily shows the write operation in the period B. The accumulation period is until immediately before time t1, and the period B, that is, the write period is from time t1 to time t10. First, immediately before time t1, the first reset signal RES is at high level, the transistor forming the first reset unit 112 is ON, and the charge-voltage converter FD is set (reset) at a voltage corresponding to the power supply potential SVDD. In addition, immediately before time t1, a second reset signal RESC is also at high level, the transistor forming the second reset unit 212 is ON, and the read node VREADP is set (reset) at a voltage corresponding to the power supply potential MVDD. Furthermore, immediately before time t1, the control signals SWN, SWA, and SWAB are also at high level, the sampling switches 213, 214, and 215 are ON, and one end of each of the memories CN, CA, and CAB is set (reset) at a voltage corresponding to the power supply potential SVDD.

Then, at time t1, the second reset signal RESC changes from high level to low level, so that the transistor forming the second reset unit 212 is switched from ON to OFF. In addition, at time t1, the control signals SWN, SWA, and SWAB change from high level to low level, so that the sampling switches 213, 214, and 215 are switched from ON to OFF. That is, each of the memories CN, CA, and CAB holds the voltage immediately before time t1. Furthermore, at time t1, the first selection signal SEL and the block selection signal BLK change from low level to high level, so that the first selection transistor 117 and the first current source switching transistor 218 are switched from OFF to ON. With this, a current flows through the first amplification transistor 111. In this state, the first amplification transistor 111 outputs, to the read node VREADP, a voltage (level) corresponding to the voltage of the charge-voltage converter FD.

Then, at time t2, the first reset signal RES changes from high level to low level. If there is no noise, the volage of the charge-voltage converter FD is maintained at the reset voltage, but in practice, it is set to a noise level corresponding to noise.

Sequentially, from time t2 to time t3, the control signal SWN is set at high level and the sampling switch 213 is switched to ON, so that a noise signal voltage (to be referred to as an N signal hereinafter) corresponding to the noise level is written in the memory CN. Then, at time t3, the control signal SWN changes from high level to low level. With this, the sampling switch 213 is switched from ON to OFF, and the memory CN holds the N signal.

Then, from time t4 to time t5, the first transport signal TXA is set at high level, the transistor forming the first transporter 113 is switched to ON, and charges in the first photoelectric converter 115 are transported to the charge-voltage converter FD. From time t5 to time t6, the control signal SWA is set at high level so that the sampling switch 214 is switched from OFF to ON. With this, a first optical signal voltage (to be referred to as an SA signal hereinafter) corresponding to charges in the first photoelectric converter 115 is written in the memory CA. Then, at time t6, the control signal SWA changes from high level to low level. With this, the sampling switch 214 is switched from ON to OFF, and the memory CA holds the SA signal.

From time t7 to time t8, the first transport signal TXA and the second transport signal TXB are set at high level, and the transistor forming the first transporter 113 and the transistor forming the second transporter 114 are switched to ON. With this, charges in the first photoelectric converter 115 and charges in the second photoelectric converter 116 are transported to the charge-voltage converter FD. In the charge-voltage converter FD, charges from the first photoelectric converter 115 and charges from the second photoelectric converter 116 are added.

From time t9 to time t10, the control signal SWAB is set at high level so that the sampling switch 215 is switched to ON. With this, a second optical signal voltage (to be referred to as an SAB signal hereinafter) corresponding to charges from the first photoelectric converter 115 and the second photoelectric converter 116 is written in the memory CAB. Then, at time t10, the control signal SWB changes from high level to low level so that the sampling switch 215 changes from high level to low level. With this, the sampling switch 215 changes from ON to OFF, and the memory CAB holds the SAB signal. In this manner, the N signal, SA signal, and SAB signal of each pixel PIX are held by the memories CN, CA, and CAB, respectively.

Fig. 6 exemplarily shows the read operation in the period C. The period B ends by time t21. The read period (one horizontal scanning period) of signals from the pixels PIX in the first row is from time t21 to time t30. Fig. 6 shows the read periods of signals from the pixels PIX in the first row and the second row.

At time t21, the selection signal SELM(1) (the number in parentheses indicates the row number) for the first row changes from low level to high level, and the second selection transistor 219 of the pixel PIX in the first row is switched from OFF to ON. In addition, at time t21, the block selection signal BLKM changes from low level to high level, and the second current source switching transistor 315 is switched from OFF to ON. With this, a current flows through the second amplification transistor 211 of the pixel PIX in the first row, so that the signal can be read from the pixel PIX in the first row.

Then, from time t21 to time t22, the second reset signal RESC is set at high level, and the voltage of the read node VREADP is set to a voltage corresponding to the power supply potential MVDD. Note that the voltage of the read node VREADP may be set to another voltage. Thereafter, from time t23 to time t24, the control signal SWN is set at high level, and the sampling switch 213 is switched to ON. With this, the N signal held by the memory CN is supplied to the gate of the second amplification transistor 211, and the second amplification transistor 211 outputs a voltage corresponding to the N signal to the output node VLOUT. The comparator circuit 311 compares the voltage of the output node VLOUT with the ramp signal RAMP, and outputs a comparison result. The latter circuit (not shown) can be configured to output, as digital data corresponding to the N signal, the time (a count value by a counter) from the start of the comparison operation by the comparator circuit 311 to the inversion of the comparison result.

Sequentially, from time t24 to time t25, the second reset signal RESC is set at high level again, and the voltage of the read node VREADP is set to the voltage corresponding to the power supply potential MVDD. This operation can reduce the influence of the state before reading the signal from the selected memory on the signal read from the selected memory.

From time t26 to time t27, the control signal SWA is set at high level, and the sampling switch 214 is switched to ON. With this, the SA signal held by the memory CA is supplied to the gate of the second amplification transistor 211, and the second amplification transistor 211 outputs a voltage corresponding to the SA signal to the output node VLOUT. The comparator circuit 311 compares the voltage of the output node VLOUT with the ramp signal RAMP, and outputs a comparison result. The latter circuit (not shown) can operate to output, as digital data corresponding to the SA signal, the time (a count value by a counter) from the start of the comparison operation by the comparator circuit 311 to the inversion of the comparison result.

Furthermore, from time t27 to time t28, the second reset signal RESC is set at high level again, and the voltage of the read node VREADP is set to the voltage corresponding to the power supply potential MVDD. From time t29 to time t30, the control signal SWAB is set at high level, and the sampling switch 215 is switched to ON. With this, the SAB signal held by the memory CAB is supplied to the gate of the second amplification transistor 211, and the second amplification transistor 211 outputs a voltage corresponding to the SAB signal to the output node VLOUT. The comparator circuit 311 compares the voltage of the output node VLOUT with the ramp signal RAMP, and outputs a comparison result. The latter circuit (not shown) can operate to output, as digital data corresponding to the SAB signal, the time (a count value by a counter) from the start of the comparison operation by the comparator circuit 311 to the inversion of the comparison result.

At time t30, the selection signal SELM(1) for the first row changes from high level to low level, and the second selection transistor 219 of the pixel PIX in the first row is switched from ON to OFF. On the other hand, at time t30, the selection signal SELM(2) for the second row changes from low level to high level, and the second selection transistor 219 of the pixel PIX in the second row is switched from OFF to ON. From time t30 to time t39, a read operation of the signal from the pixel PIX in the second row is performed similarly to the read operation of the signal form the pixel PIX in the first row. Thereafter, the signals from the pixels from the third row up to the final row are similarly read.

The block selection signal BLKM can change from high level to low level at the timing of the end of the period C.

In the example described above, the N signal, the SA signal, and the SAB signal are read from each pixel, but this is merely an example. For example, the N signal, the SA signal, and an SB signal may be read from each pixel (the SB signal is an optical signal level read from the photoelectric converter 116). Alternatively, the N signal and the SAB signal may be read from each pixel. Alternatively, the N signal, the SB signal, and the SAB signal may be read from each pixel.

Note that the above-described arrangement and operation of the photoelectric conversion device are merely examples for facilitating understanding, and the overall arrangement of the photoelectric conversion device, the arrangement of each pixel, the driving method of each pixel, and the like can be changed, as appropriate.

In this embodiment, the first current source CS1 (first current source transistor 217) is configured or controlled to supply the first current to the first amplification transistor 111. The second current source CS2 (second current source transistor 314) is configured or controlled to supply the second current to the second amplification transistor 211. Here, the first current (magnitude thereof) is preferably smaller than the second current (magnitude thereof). This can be adjusted by, for example, the voltage levels of the control voltages VBIAS1 and VBIAS2 generated by the bias generation circuits 230 and 330, respectively. For example, if the first current source transistor 217 and the second current source transistor 314 are formed by NMOS transistors, the first current (magnitude thereof) can be made smaller than the second current (magnitude thereof) by setting VBIAS1 < VBIAS2. It is preferable that the first current (magnitude thereof) satisfies at least one of the following conditions: less than 90%, less than 80%, less than 70%, less than 60%, less than 50%, less than 40%, less than 30%, less than 20%, and less than 10% of the second current (magnitude thereof). Alternatively, it is preferable that the first current (magnitude thereof) satisfies at least one of the following conditions: less than 1/2, less than 1/4, less than 1/8, less than 1/16, less than 1/32, less than 1/64, less than 1/128, less than 1/256, and less than 1/512 of the second current (magnitude thereof).

The advantages of making the first current (magnitude thereof) smaller than the second current (magnitude thereof) will be described below. One first amplification transistor 111, to which one first current source CS1 (first current source transistor 217) supplies the first current, writes a signal in only one of the memories CN, CA, and CAB at a time. Therefore, the current (magnitude thereof) required for one first current source CS1 (first current source transistor 217) is relatively small.

On the other hand, one second amplification transistor 211, to which the second current source CS2 (second current source transistor 314) supplies the second current, needs to drive the load (capacitance) of the read line 316 extending in the column direction and the multiple second selection transistors 219 connected thereto. Therefore, the current (magnitude thereof) required for one second current source CS2 (second current source transistor 314) is relatively large. Hence, the first current (magnitude thereof) may be smaller than the second current (magnitude thereof). In the global shutter mode, the first current sources CS1 (first current source transistors 217) of the plurality of pixels PIX constituting the pixel array PA operate simultaneously in the period B (write period). Therefore, making the first current (magnitude thereof) smaller than the second current (magnitude thereof) is useful for suppressing the peak value of current consumption. By suppressing the peak value of current consumption, the power supply potential and the ground potential can be stabilized, and this is advantageous in reducing noise. In addition, suppressing the peak value of current consumption is also advantageous in reducing the amount of power consumption.

Each of Figs. 4B and 4C schematically shows the operation of the photoelectric conversion device 10 in the partial global shutter (PGS) mode. Each of Figs. 4B and 4C shows an example in which the plurality of pixels PIX constituting the pixel array PA are divided into a plurality of (N) blocks, that is, blocks BLK1 to BLKN. First, the period A (accumulation period) will be described. In the partial global shutter (PGS) mode, the period A (accumulation period) is decided for each block. In the example shown in each of Figs. 4B and 4C, N periods A (accumulation periods) corresponding to N blocks BLK1 to BLKN, respectively, are decided. Here, the first vertical scanning circuit 120 can be configured to control the plurality of pixels PIX such that the period during which each of the plurality of pixels PIX performs the accumulation operation is the same within each individual block and different between the plurality of blocks. The first vertical scanning circuit 120 controls the plurality of pixels PIX such that the timing at which each of the plurality of pixels PIX starts the accumulation operation is the same within each individual block and different between the plurality of blocks. In addition, the first vertical scanning circuit 120 controls the plurality of pixels PIX such that the timing at which each of the plurality of pixels PIX ends the accumulation operation is the same within each individual block and different between the plurality of blocks. On the other hand, the first vertical scanning circuit 120 controls the plurality of pixels PIX such that the length of the period of the accumulation operation in each of the plurality of pixels PIX is the same in all blocks, in other words, the same in all pixels PIX.

In the example shown in Fig. 4B, the read circuit 310 starts the period C (read period) before the period A (accumulation period) and the period B (write period) end in all of the plurality of pixels PIX. In another viewpoint, in the example shown in Fig. 4B, the read operation (the operation in the period C) in one block is performed in parallel with the operation in the period A or the period B (the operation in the period A or B) in another block. In the example shown in Fig. 4B, for example, the read circuit 310 performs the read operation of signals from each block when the write operation ends in each block.

In the example shown in Fig. 4C, the read circuit 310 starts the period C (read period) after the period A (accumulation period) and the period B (write period) end in all of the plurality of pixels PIX. The example shown in Fig. 4C is advantageous in suppressing the peak value of current consumption in the photoelectric conversion device 10.

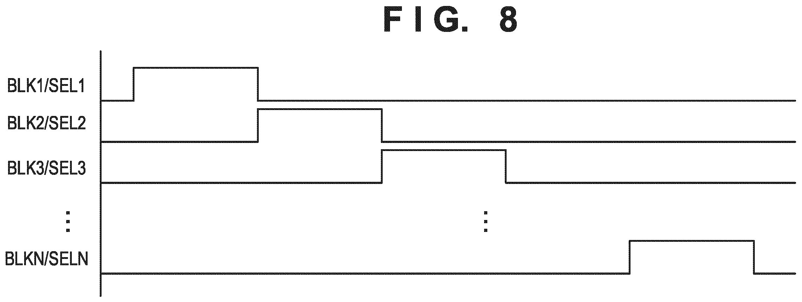

The partial global shutter (PGS) mode can be implemented by, for example, providing the first selection signal SEL and the block selection signal BLK for each block so that they can be individually controlled for each block. More specifically, a plurality of first selection signals SEL1, SEL2, .., SELN and a plurality of block selection signals BLK1, BLK2, .., BLKN are provided, and they may be driven as exemplarily shown in Fig. 8.

Letting $I_{PGS}$ be the peak value of current consumption of the first current source CS1 in the period A of the partial global shutter (PGS) mode, and $I_{GS}$ be the peak value of current consumption of the first current source CS1 in the period A of the global shutter (GS) mode, $I_{PGS} = I_{GS}/N$ holds. N is the number of blocks. In the partial global shutter mode as well, the control voltages VBIAS1 and VBIAS2 generated by the bias generation circuits 230 and 330 may be adjusted to make the first current (magnitude thereof) smaller than the second current (magnitude thereof).

In the example described above, the plurality of pixels PIX constituting the pixel array PA are divided into N blocks, and the accumulation period and the write period are controlled for each block, but the accumulation period and the write period may be controlled for two or more predetermined number of blocks.

The size (for example, the number of rows) of the block can be decided such that the number of rows to execute the write operation per unit time is larger than the number of rows to execute the read operation per unit time.

In accordance with making the first current flowing from the first current source CS1 smaller than the second current flowing from the second current source CS2, the W/L ratio of the first amplification transistor 111 may be made smaller than the W/L ratio of the second amplification transistor 211. Alternatively, in accordance with making the first current flowing from the first current source CS1 smaller than the second current flowing from the second current source CS2, the area of the first amplification transistor 111 (active region thereof) may be made smaller than the area of the second amplification transistor 211 (active region thereof).

The W/L ratio and the area of the transistor will be described below. A current I flowing between the source and drain of a transistor is expressed by:

$$I = \beta(W/L) \cdot (Vgs - Vth) \qquad\qquad ...(1)$$

where β is a gain coefficient, W is a channel width, L is a channel length, Vgs is a gate-source voltage, and Vth is a threshold voltage.

The channel width W and the channel length L are decided by the arrangement of the transistor. As expressed by equation (1), the current I flowing between the source and drain of the transistor is proportional to the W/L ratio of the channel width W and the channel length L of the transistor. In accordance with making the first current flowing from the first current source CS1 smaller than the second current flowing from the second current source CS2, the current allowed to flow through the first amplification transistor 111 can be made smaller than the current allowed to flow through the second amplification transistor 211.

Accordingly, in accordance with making the first current flowing from the first current source CS1 smaller than the second current flowing from the second current source CS2, the W/L ratio of the first amplification transistor 111 may be made lower than the W/L ratio of the second amplification transistor 211. If the channel length L of the first amplification transistor 111 is equal to the channel length L of the second amplification transistor 211, the channel width W of the first amplification transistor 111 may be made smaller than the channel width W of the second amplification transistor 211. In other words, the area of the first amplification transistor 111 (active region thereof) may be made smaller than the area of the second amplification transistor 211 (active region thereof). Making the small area of the first amplification transistor 111 (active region thereof) is advantageous in reducing the pixel size.

To make the first current flowing from the first current source CS1 smaller than the second current flowing from the second current source CS2, the W/L ratio of the first current source transistor 217 may be made lower than the W/L ratio of the second current source transistor 314. If the channel length L of the first current source transistor 217 is equal to the channel length L of the second current source transistor 314, the channel width W of the first current source transistor 217 may be made smaller than the channel width W of the second current source transistor 314. In other words, the area of the first current source transistor 217 (active region thereof) may be made smaller than the area of the second current source transistor 314 (active region thereof).

[Application Example]

One application example of the photoelectric conversion device 10 is an image capturing device that generates an image (image data) by capturing an optical image. Other application examples of the photoelectric conversion device are a distance measurement device (a device for focus detection, distance measurement using Time Of Flight (TOF), or the like) and a light measurement device (a device for measuring the incident light amount or the like).

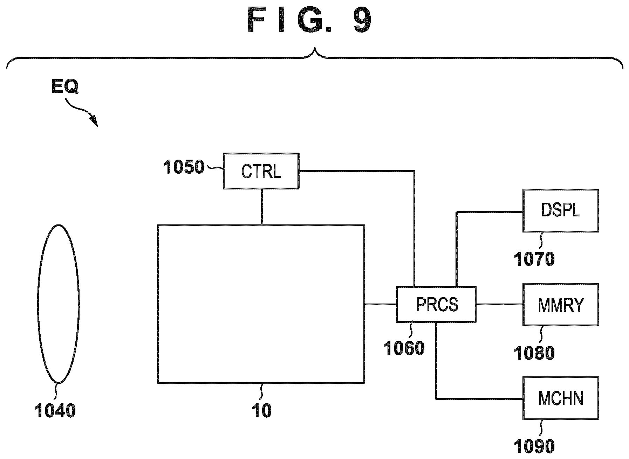

With reference to Fig. 9, equipment EQ incorporating the photoelectric conversion device 10 will be described below. The equipment EQ can include at least one of the photoelectric conversion device 10 configured as an image sensor, an optical device 1040, a control device 1050, a processing device 1060, a display device 1070, a storage device 1080, and a mechanical device 1090. The optical device 1040 is implemented by, for example, a lens, a shutter, and a mirror. The control device 1050 controls the semiconductor chip 210. The control device 1050 is, for example, a semiconductor device such as an ASIC.

The processing device 1060 processes a signal output from the semiconductor chip 210. The processing device 1060 is a semiconductor device such as a CPU or an ASIC for forming an Analog Front End (AFE) or a Digital Front End (DFE). The display device 1070 is an EL display device or a liquid crystal display device that displays information (image) obtained by the semiconductor chip 210. The storage device 1080 is a magnetic device or a semiconductor device that stores the information (image) obtained by the semiconductor chip 210. The storage device 1080 is a volatile memory such as an SRAM or a DRAM, or a nonvolatile memory such as a flash memory or a hard disk drive.

The mechanical device 1090 includes a moving or propulsion unit such as a motor or an engine. In the equipment EQ, the signal output from the semiconductor chip 210 is displayed on the display device 1070 or transmitted to an external device by a communication device (not shown) included in the equipment EQ. Hence, the equipment EQ may further include the storage device 1080 and the processing device 1060 in addition to the memory circuits and arithmetic circuits included in the semiconductor chip 210. The mechanical device 1090 may be controlled based on the signal output from the semiconductor chip 210.

In addition, the equipment EQ is suitable for electronic equipment such as an information terminal (for example, a smartphone or a wearable terminal) which has a shooting function or a camera (for example, an interchangeable lens camera, a compact camera, a video camera, or a monitoring camera). The mechanical device 1090 in the camera can drive the components of the optical device 1040 in order to perform zooming, an in-focus operation, and a shutter operation. Alternatively, the mechanical device 1090 in the camera can move the semiconductor chip 210 in order to perform an anti-vibration operation.

Furthermore, the equipment EQ can be transportation equipment such as a vehicle, a ship, or an airplane. The mechanical device 1090 in the transportation equipment can be used as a moving device. The equipment EQ as the transportation equipment is suitable for equipment that transports the semiconductor chip 210 or equipment that uses an shooting function to assist and/or automate driving (steering). The processing device 1060 for assisting and/or automating driving (steering) can perform, based on the information obtained by the semiconductor chip 210, processing for operating the mechanical device 1090 as a moving device. Alternatively, the equipment EQ may be medical equipment such as an endoscope, measurement equipment such as a distance measurement sensor, analysis equipment such as an electron microscope, office equipment such as a copy machine, or industrial equipment such as a robot.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A photoelectric conversion device that comprises a pixel array including a plurality of pixels arranged to form a plurality of rows and a plurality of columns, and a read circuit including a plurality of column circuits configured to read signals from the pixel array, wherein

   each pixel includes a photoelectric converter configured to accumulate charges corresponding to incident light, a charge-voltage converter, a transporter configured to transport charges from the photoelectric converter to the charge-voltage converter, a first amplification transistor configured to amplify a voltage of the charge-voltage converter, a first current source configured to supply a first current to the first amplification transistor, a storage configured to hold an output of the first amplification transistor, and a second amplification transistor configured to amplify a voltage supplied from the storage,
   each column circuit includes a second current source configured to supply a second current to the second amplification transistor, and
   the first current is smaller than the second current.

2. The device according to claim 1, further comprising a controller configured to control the plurality of pixels, wherein the controller causes the plurality of pixels to simultaneously perform a write operation of transporting charges from the photoelectric converter to the charge-voltage converter by the transporter and writing an output of the first amplification transistor in the storage.

3. The device according to claim 1, further comprising a controller configured to control the plurality of pixels divided into a plurality of blocks, wherein the controller controls the plurality of pixels such that a period during which each of the plurality of pixels performs a write operation of transporting charges from the photoelectric converter to the charge-voltage converter by the transporter and writing an output of the first amplification transistor in the storage by the storage is the same within each individual block and different between the plurality of blocks.

4. The device according to claim 3, wherein the read circuit performs an read operation of signals from each block when the write operation ends in each block.

5. The device according to claim 3, wherein the read circuit starts a read operation of signals from the plurality of pixels after the write operation ends in all of the plurality of blocks.

6. The device according to any one of claims 3 to 5, wherein

   each pixel further includes a first control transistor,

the first amplification transistor, the first current source, and the first control transistor are connected in series, and the controller performs the write operation by turning on the first control transistor.

7. The device according to any one of claims 1 to 6, wherein

the first current source includes a first current source transistor, and the second current source includes a second current source transistor, and
voltages are respectively supplied to a gate of the first current source transistor and a gate of the second current source transistor such that the first current is smaller than the second current.

8. The device according to any one of claims 1 to 7, wherein a W/L ratio indicating a ratio of a channel width W and a channel length L of the first amplification transistor is lower than a W/L ratio of the second amplification transistor.

9. The device according to any one of claims 1 to 7, wherein an area of the first amplification transistor is smaller than an area of the second amplification transistor.

10. The device according to any one of claims 1 to 9, wherein the first current source includes a series connection of a first current source transistor and a first cascode transistor.

11. The device according to any one of claims 1 to 10, wherein the second current source includes a series connection of a second current source transistor and a second cascode transistor.

12. The device according to any one of claims 1 to 11, wherein the read circuit is arranged in a substrate different from a substrate where at least a second amplification transistor of each of the plurality of pixels is arranged.

13. The device according to any one of claims 1 to 12, wherein

each column circuit includes a read line, and
the second amplification transistor of each of pixels forming one column among the plurality of pixels is connected to the read line of a corresponding column circuit among the plurality of column circuits.

14. The device according to claim 13, wherein

each pixel further includes a selection transistor, and
the second amplification transistor of each of pixels forming one column among the plurality of pixels is connected, via the selection transistor, to the read line of a corresponding column circuit among the plurality of column circuits.

15. The device according to any one of claims 1 to 14, wherein components of the plurality of pixels are arranged in not less than two substrates.

16. Equipment comprising:

a photoelectric conversion device defined in any one of claims 1 to 15; and
a processing device configured to process a signal output from the photoelectric conversion device.

# F I G. 1

FIG. 2

IMAGE DATA

F I G. 3

EP 4 637 174 A1

EP 4 637 174 A1

**F I G. 4A**

A: ACCUMULATION PERIOD
B: WRITE PERIOD
C: READ PERIOD

**F I G. 4B**

A: ACCUMULATION PERIOD
B: WRITE PERIOD
C: READ PERIOD

**F I G. 4C**

A: ACCUMULATION PERIOD
B: WRITE PERIOD
C: READ PERIOD

# FIG. 5

# FIG. 6

# F I G. 7

PA

| BLK1 |
|:---:|
| BLK2 |
| BLK3 |
| ⋮ |
| BLKN |

**FIG. 8**

BLK1/SEL1

BLK2/SEL2

BLK3/SEL3

...

BLKN/SELN

# F I G. 9

EQ

1050 — CTRL

1040

10

1060 PRCS

DSPL

1070

MMRY

1080

MCHN

1090

| | Europäisches Patentamt European Patent Office Office européen des brevets | **EUROPEAN SEARCH REPORT** | **Application Number** EP 25 16 9351 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2023/062935 A1 (SONY SEMICONDUCTOR SOLUTIONS CORP [JP]) 20 April 2023 (2023-04-20) | 1,2,7-9, 12-16 | INV. H04N25/532 H04N25/616 |
| Y | * abstract * | 3-6,10, 11 | H04N25/709 H04N25/771 |
| | & US 2024/373143 A1 (KATO HIROMU [JP] ET AL) 7 November 2024 (2024-11-07) * abstract * * figures 1, 2, 3, 4, 5, 6, 11, 15, 17, 41 * * paragraph [0083] - paragraph [0084] * * paragraph [0088] * * paragraph [0092] * * paragraph [0116] - paragraph [0125] * * paragraph [0096] - paragraph [0109] * * paragraph [0146] - paragraph [0148] * * paragraph [0132] * * paragraph [0287] * ----- | | H04N25/778 H04N25/78 H04N25/79 H04N23/73 H10F39/00 |
| Y | US 2009/072120 A1 (MCGARRY E JOHN [US] ET AL) 19 March 2009 (2009-03-19) * abstract * * figures 19H-G * * paragraph [0010] - paragraph [0011] * * paragraph [0134] * ----- | 3-6 | **TECHNICAL FIELDS SEARCHED (IPC)** H04N H01L H10F |
| Y | US 2019/052788 A1 (LIU XINQIAO [US]) 14 February 2019 (2019-02-14) * abstract * * figure 3 * * paragraph [0005] - paragraph [0006] * ----- -/-- | 3-6 | |

The present search report has been drawn up for all claims

| Place of search | Date of completion of the search | Examiner |
|---|---|---|
| Munich | 26 June 2025 | Furlan, Silvano |

EPO FORM 1503 03.82 (P04C01)

page 1 of 2

| | Europäisches Patentamt European Patent Office Office européen des brevets | **EUROPEAN SEARCH REPORT** | **Application Number** EP 25 16 9351 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SHIKE HIROYA ET AL: "A Global Shutter Wide Dynamic Range Soft X-Ray CMOS Image Sensor With Backside- Illuminated Pinned Photodiode, Two-Stage Lateral Overflow Integration Capacitor, and Voltage Domain Memory Bank", IEEE TRANSACTIONS ON ELECTRON DEVICES, IEEE, USA, vol. 68, no. 4, 15 March 2021 (2021-03-15) , pages 2056-2063, XP011845247, ISSN: 0018-9383, DOI: 10.1109/TED.2021.3062576 [retrieved on 2021-03-23] * abstract * * figure 2 * | 6 | |
| A | US 2022/191418 A1 (JUNG HYUNYONG [KR] ET AL) 16 June 2022 (2022-06-16) * abstract * * figure 3 * * paragraph [0059] - paragraph [0060] * | 6 | |
| Y | WO 2023/048235 A1 (SONY SEMICONDUCTOR SOLUTIONS CORP [JP]) 30 March 2023 (2023-03-30) * abstract * & US 2025/126375 A1 (KUMAGAI YOSHIMICHI [JP] ET AL) 17 April 2025 (2025-04-17) * abstract * * figure 2 * * paragraph [0120] - paragraph [0122] * | 10,11 | TECHNICAL FIELDS SEARCHED (IPC) |

The present search report has been drawn up for all claims

| Place of search | Date of completion of the search | Examiner |
|---|---|---|
| Munich | 26 June 2025 | Furlan, Silvano |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 9351

This annex lists the patent family members relating to the patent documents cited in the above-mentioned European search report.
The members are as contained in the European Patent Office EDP file on
The European Patent Office is in no way liable for these particulars which are merely given for the purpose of information.

26-06-2025

| Patent document cited in search report | Publication date | Patent family member(s) | | Publication date |
|---|---|---|---|---|
| WO 2023062935 A1 | 20-04-2023 | CN | 117837164 A | 05-04-2024 |
| | | DE | 112022004951 T5 | 14-08-2024 |
| | | JP | WO2023062935 A1 | 20-04-2023 |
| | | US | 2024373143 A1 | 07-11-2024 |
| | | WO | 2023062935 A1 | 20-04-2023 |
| US 2009072120 A1 | 19-03-2009 | EP | 2186317 A1 | 19-05-2010 |
| | | JP | 5258886 B2 | 07-08-2013 |
| | | JP | 2010536252 A | 25-11-2010 |
| | | US | 2009072120 A1 | 19-03-2009 |
| | | WO | 2009035785 A1 | 19-03-2009 |
| US 2019052788 A1 | 14-02-2019 | TW | 201911857 A | 16-03-2019 |
| | | US | 2019052788 A1 | 14-02-2019 |
| | | WO | 2019036238 A1 | 21-02-2019 |
| US 2022191418 A1 | 16-06-2022 | KR | 20220082566 A | 17-06-2022 |
| | | US | 2022191418 A1 | 16-06-2022 |
| | | US | 2024179435 A1 | 30-05-2024 |
| WO 2023048235 A1 | 30-03-2023 | CN | 117837165 A | 05-04-2024 |
| | | DE | 112022004720 T5 | 01-08-2024 |
| | | EP | 4412238 A1 | 07-08-2024 |
| | | JP | WO2023048235 A1 | 30-03-2023 |
| | | KR | 20240088707 A | 20-06-2024 |
| | | TW | 202322378 A | 01-06-2023 |
| | | US | 2025126375 A1 | 17-04-2025 |
| | | WO | 2023047631 A1 | 30-03-2023 |
| | | WO | 2023048235 A1 | 30-03-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022051548 A